# EUROPÄISCHE PATENTSCHRIFT

(11) **EP 2 847 853 B1**
(45) Veröffentlichungstag und Bekanntmachung des Hinweises auf die Patenterteilung: **21.12.2016**
(21) Anmeldenummer: 13731055.3
(22) Anmeldetag: 11.06.2013
(51) Int. Cl.: H02K 11/00, H02K 15/00, G01R 31/34

(54) **ÜBERWACHUNGSSYSTEM FÜR EINE ELEKTRISCHE MASCHINE**
MONITORING SYSTEM FOR AN ELECTRIC MACHINE
SYSTÈME DE SURVEILLANCE POUR UNE MACHINE ÉLECTRIQUE

(30) Priorität: 24.07.2012 EP 12177578
(43) Veröffentlichungstag der Anmeldung: 18.03.2015
(73) Patentinhaber: Siemens Aktiengesellschaft, 80333 München (DE)
(72) Erfinder: KOWALSKI, Waldemar, 45472 Mülheim an der Ruhr (DE); LEHMANN, Christoph, 47506 Neukirchen-Vluyn (DE)
(86) Internationale Anmeldenummer: PCT/EP2013/061970
(87) Internationale Veröffentlichungsnummer: WO 2014/016036

(56) Entgegenhaltungen:
- EP-A2- 1 862 381
- WO-A1-94/00738
- DE-U1-202009 015 603

## Beschreibung

Die Erfindung betrifft ein Überwachungssystem zur Überwachung einer elektrischen Maschine, wobei die elektrische Maschine ein Gehäuse und eine im Gehäuse angeordnete Ständerwicklung mit einem Ständerwickelkopf aufweist.

Elektrische Maschinen wie z.B. elektrische Generatoren sind im Wesentlichen aus einem sich beweglichen Teil, dem Ständerrotor und einem unbeweglichen Teil, dem Ständer ausgebildet. Der Rotor umfasst eine Rotorwicklung, die im Wesentlichen großvolumige Kupferleitungen sind, die über eine Erregereinrichtung mit Strom zur Erzeugung eines Magnetfeldes versorgt werden. Das sich drehende Magnetfeld induziert eine Spannung in auf dem Ständer geeignet angeordneten elektrisch leitenden Ständerwicklungen. Üblicherweise werden solche elektrischen Generatoren derart ausgeführt, dass an den Enden der Ständerwicklung die elektrischen Leitungen zu einem Ständerwickelkopf ausgebildet sind.

Während des Betriebes einer elektrischen Maschine führen verschiedene physikalische Effekte zu einer Belastung der einzelnen Bauteile. So wird zum einen durch einen elektrischen Widerstand sowohl in der Ständerwicklung als auch in der Rotorwicklung Energie dissipiert, die zu einer thermischen Beanspruchung der einzelnen Bauteile führt. Des Weiteren werden die Rotoren in der Regel bei vergleichsweise hohen Drehzahlen wie bspw. 50 bzw. 60 Hz betrieben, was zu enormen Fliehkräften und zu mechanischen Belastungen führt. Solch hohe Drehzahlen führen nicht nur zu höheren Belastungen im Rotor, sondern auch im Ständer, insbesondere im Ständerwickelkopf. Die durch die Rotation einhergehenden Vibrationen bzw. Schwingungen können die Lebensdauer solch ausgeführter elektrischer Generatoren verkürzen.

Elektrische Generatoren werden in der Regel mit Luft, Wasserstoff oder Wasser gekühlt, je nach elektrischem Leistungsbedarf. Das Kühlmedium wird in einem Gehäuse im elektrischen Generator im Wesentlichen hermetisch geführt, so dass das Gehäuse im Wesentlichen gasdicht gegenüber der Umgebung ausgebildet ist.

In der Regel werden die Generatoren auf Dauerbetrieb ausgelegt und dementsprechend ausgelastet. Bei Inspektionsarbeiten, die im Stillstand des elektrischen Generators durchgeführt werden, werden die Ständerwickelköpfe durch einen Befunder visuell inspiziert. Dazu wird ein Zugang durch eine Öffnung, bspw. durch so genannte Mannlochdeckel ermöglicht, wodurch eine visuelle Inspektion möglich wird. Dennoch sind solche Platzverhältnisse derart beengt, dass nur durch eine teilweise Demontage von weiteren Generatorkomponenten, wie z.B. der Schildlageroberteile, der Zugang zu den Ständerwickelköpfen möglich ist.

Ein weiteres Problem ist, dass insbesondere bei mit Wasserstoff gekühlten Generatoren das Kühlungsmedium (Wasserstoff) aus dem Inneren des elektrischen Generators gespült werden muss, was einen erheblichen Aufwand bedeutet. Selbst nach vermeintlich erfolgreichem Ausblasen und Spülen der elektrischen Maschine mit Inertgas muss die elektrische Maschine, bevor sie begangen werden kann, noch abgesichert werden, indem Formaldehyd und Sauerstoffkonzentrationsmessungen durchgeführt werden.

Das Dokument DE 20 2009 015603 offenbart eine elektrische Maschine mit einem Überwachungssystem. Dabei wird eine Digitalkamera ortsfest angeordnet.

Die EP 1 862 381 A2 offenbart ein Gerät, das zur Anwendung in einem Luftspalt ausgebildet ist.

Das Dokument WO 94/00738 A1 offenbart eine Inspektionseinheit an einer dynamoelektrischen Maschine.

Wünschenswert wäre es eine Inspektionsmöglichkeit zu haben, die einen gegenüber dem Stand der Technik geringeren Aufwand bedeutet.

Aufgabe der Erfindung ist es daher, ein Überwachungssystem anzubieten, mit dem mit geringem Aufwand eine elektrische Maschine inspiziert werden kann.

Gelöst wird diese Aufgabe durch eine elektrische Maschine gemäß Anspruch 1.

Des Weiteren wird diese Aufgabe durch ein Verfahren gemäß Anspruch 10 gelöst.

Die wesentliche Idee der Erfindung ist es, eine geeignete Minikamera im Bereich des Ständerwickelkopfes anzuordnen, statt die elektrische Maschine zu öffnen, was einen erheblichen Aufwand bedeuten würde. Die Minikamera wird mit einer geeigneten Übertragungsmöglichkeit, entweder durch drahtlose Übertragung oder mit drahtgebundener Übertragung mit einem Auswertesystem verbunden. Die elektrische Maschine kann daher von einem Beobachter, der außerhalb des Generators sich befindet, überwacht werden. Die Überwachung kann daher während des Betriebs erfolgen.

Die Minikamera wird auf Führungselementen bewegbar angeordnet.

Die Führungsschienen sind derart angeordnet, dass die Kamera in Betrieb in einer sicheren und unkritischen Parkstellung angeordnet ist. Diese Parkstellung wird derart gewählt, dass die Spannungsabstände eingehalten werden und außerdem die herrschenden mechanischen Belastungen, wie z.B. Kühlgasströmungen betrachtet werden. Somit kann die Kamera in einer sicheren Position gehalten werden.

Vorteilhafte Weiterbildungen sind in den Unteransprüchen angegeben.

So wird in einer ersten vorteilhaften Weiterbildung das Gehäuse im Wesentlichen gasdicht geschlossen ausgeführt. Des Weiteren wird vorteilhafterweise die elektrische Maschine mit einer Wasserstoffkühlung ausgeführt. Das bedeutet, dass das erfindungsgemäße Überwachungssystem besonders geeignet ist für Wasserstoff gekühlte Generatoren, die bekanntermaßen ja besonders gasdicht ausgebildet sind. In einer weiteren vorteilhaften Weiterbildung wird die Minikamera mit einer Lichtquelle ausgeführt. Diese Lichtquelle müsste derart dimensioniert sein, dass die mit der Kamera notwendige Einsicht auf die zu betrachtenden Elemente bzw. Komponenten in der elektrischen Maschine garantiert ist.

Die Führungselemente können als Schienen ausgebildet sein und werden so gestaltet, dass eine Führung der Kamera derart erfolgen kann, dass die notwendige Einsicht auf die zu betrachtenden kritischen Elemente bzw. Komponenten garantiert ist.

Vorteilhafterweise ist das Führungselement unmagnetisch ausgebildet.

Vorteilhafterweise wird die das Führungselement in Kreisbahnen um den Ständerwickelkopf geführt.

Im Folgenden wird die Erfindung anhand eines Ausführungsbeispieles nun näher erläutert.

Es zeigt:

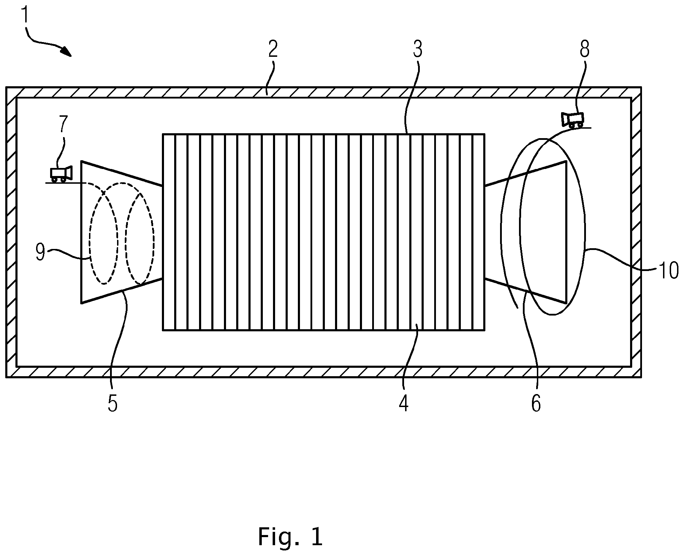

Figur 1 eine schematische Ansicht des Überwachungssystems.

Die Figur 1 zeigt in schematischer Weise einen elektrischen Generator 1 als Ausführungsform einer elektrischen Maschine. Der elektrische Generator 1 umfasst im Wesentlichen ein Generatorgehäuse 2, das im Wesentlichen gasdicht geschlossen ist. Innerhalb des Generatorgehäuses 2 ist ein nicht näher dargestellter Rotor drehbar angeordnet, der im Wesentlichen bei 50 Hz bzw. 60 Hz rotiert. Um den Rotor ist eine Ständerwicklung 3 und ein Blechpaket 4 angeordnet, in dem eine elektrische Spannung induziert werden kann. An den jeweiligen Enden der Ständerwicklung 3 sind ein erster Ständerwickelkopf 5 und ein zweiter Ständerwickelkopf 6 angeordnet. Sowohl der erste Ständerwickelkopf 5 als auch der zweite Ständerwickelkopf 6 neigen in Betrieb zu unerwünschten Schwingungen. Im schlimmsten Fall können solche Schwingungen eine Zerstörung des ersten Ständerwickelkopfes 5 und des zweiten Ständerwickelkopfes 6 bewirken.

Über nicht näher dargestellte Kühlmöglichkeiten wird innerhalb des Generatorgehäuses 2 die Ständerwicklung 3 mit bspw. Wasserstoff gekühlt. Daher ist das Generatorgehäuse 2 gasdicht ausgeführt. Das Überwachungssystem zur Überwachung der elektrischen Maschine 1 umfasst die elektrische Maschine 1 und das Generatorgehäuse 2, wobei im Generatorgehäuse 2 eine Ständerwicklung angeordnet ist, umfassend einen Ständerwickelkopf 5, 6. Innerhalb des Generatorgehäuses 2 ist eine Minikamera 7, 8 angeordnet, die zur Beobachtung der elektrischen Maschine 1, insbesondere des ersten Ständerwickelkopfes 5 als auch des zweiten Ständerwickelkopfes 6 ausgebildet ist. Die Minikamera 7, 8 ist mit einer nicht näher dargestellten Lichtquelle ausgeführt und auf Führungselementen 9, 10 bewegbar angeordnet. Diese Führungselemente 9, 10 sind als Schienen ausgebildet und zweckmäßigerweise unmagnetisch ausgeführt, da die im elektrischen Generator 1 herrschenden Magnetfelder zu Störungen führen könnten.

Die Führungselemente 9, 10 sind in Kreisbahnen um den ersten Ständerwickelkopf 5 als auch um den zweiten Ständerwickelkopf 6 geführt.

In nicht näher dargestellter Weise sind die Führungselemente 9, 10 derart ausgebildet, dass während des Betriebs der elektrischen Maschine 1 die Minikamera 7, 8 in einer unkritischen Parkposition gehalten ist.

Der Vorteil der Erfindung ist, dass der elektrische Generator 1 im Falle einer visuellen Inspektion nicht geöffnet bzw. nicht teildemontiert werden muss. Des Weiteren muss der wasserstoffgekühlte elektrische Generator 1 nicht ausgeblasen und nach Verschließen wieder abgedrückt werden. Die Inspektion durch das erfindungsgemäße Überwachungssystem zeigt eine verbesserte Qualität durch definierte und gleichbleibende Betrachtung der Komponenten.

Darüber hinaus ist mit der erfindungsgemäßen Überwachungseinheit eine große Zeiteinsparung möglich. Dadurch ist eine resultierende bessere Trendbetrachtung möglich. Außerdem werden keine Ersatzteile beim Verschließen des Generators 1 bspw. Dichtungen oder neue Verschraubungselemente notwendig sein. Das Überwachungssystem ist hierbei derart ausgebildet, dass eine Überwachung der elektrischen Maschine 1 während des Betriebs möglich ist.

## Patentansprüche

1. Elektrische Maschine (1) mit einem Überwachungssystem zur Überwachung der elektrischen Maschine (1),
wobei die elektrische Maschine (1) ein Generatorgehäuse (2) und eine im Generatorgehäuse (2) angeordnete Ständerwicklung (3) mit einem Ständerwickelkopf (5, 6) aufweist, wobei innerhalb des Generatorgehäuses (2) eine Minikamera (7, 8) zur Beobachtung des Ständerwickelkopfes (5, 6) angeordnet ist,
wobei die Minikamera (7, 8) auf Führungselementen (9, 10) bewegbar angeordnet ist,
wobei die Führungselemente (9, 10) derart ausgebildet sind, dass während des Betriebs der elektrischen Maschine (1) die Minikamera (7, 8) in einer unkritischen Parkposition gehalten ist.

2. Elektrische Maschine (1) nach Anspruch 1,
derart ausgebildet,
dass eine Beobachtung des Ständerwickelkopfes (5, 6) während des Betriebs der elektrischen Maschine (1) erfolgt.

3. Elektrische Maschine (1) nach Anspruch 1 oder 2,
wobei das Generatorgehäuse (2) im Wesentlichen gasdicht geschlossen ausgeführt ist.

4. Elektrische Maschine (1) nach Anspruch 1, 2 oder 3,
wobei die elektrische Maschine (1) mit einer Wasserstoffkühlung ausgeführt ist.

5. Elektrische Maschine (1) nach einem der vorhergehenden Ansprüche,
wobei die Minikamera (7, 8) mit Lichtquelle ausgeführt ist.

6. Elektrische Maschine (1) nach Anspruch 1,
wobei das Führungselement (9, 10) als Schiene ausgebildet ist.

7. Elektrische Maschine (1) nach Anspruch 1 oder 6,
wobei das Führungselement (9, 10) unmagnetisch ausgebildet ist.

8. Elektrische Maschine (1) nach einem der Ansprüche 1 bis 7,
wobei das Führungselement (9, 10) in Kreisbahnen um den Ständerwickelkopf (5, 6) geführt ist.

9. Elektrische Maschine (1) nach einem der vorhergehenden Ansprüche,
geeignet zur Überwachung einer als elektrischer Generator ausgeführten elektrischen Maschine (1).

10. Verfahren zur Überwachung eines Ständerwickelkopfes (5, 6) einer elektrischen Maschine (1) nach einem der Ansprüche 1 bis 9,
wobei das Überwachungssystem während des Betriebs der elektrischen Maschine (1) eingesetzt wird.

## Claims

1. Electric machine (1) comprising a monitoring system for monitoring the electric machine (1),
wherein the electric machine (1) has a generator housing (2) and a stator winding (3) comprising a stator end winding (5, 6), which stator winding is arranged in the generator housing (2), wherein a minicamera (7, 8) for observing the stator end winding (5, 6) is arranged within the generator housing (2), wherein the minicamera (7, 8) is arranged movably on guide elements (9, 10), wherein the guide elements (9, 10) are designed in such a way that the minicamera (7, 8) is held in an uncritical parked position during the operation of the electric machine (1).

2. Electric machine (1) according to Claim 1,
which is designed in such a way
that the stator end winding (5, 6) is observed during operation of the electric machine (1).

3. Electric machine (1) according to Claim 1 or 2,
wherein the generator housing (2) is substantially sealed in a gas-tight manner.

4. Electric machine (1) according to Claim 1, 2 or 3, wherein the electric machine (1) is embodied with hydrogen cooling.

5. Electric machine (1) according to one of the preceding claims,
wherein the minicamera (7, 8) is embodied with a light source.

6. Electric machine (1) according to Claim 1,
wherein the guide element (9, 10) is in the form of a rail.

7. Electric machine (1) according to Claim 1 or 6,
wherein the guide element (9, 10) is nonmagnetic.

8. Electric machine (1) according to one of Claims 1 to 7, wherein the guide element (9, 10) is guided in circular paths around the stator end winding (5, 6).

9. Electric machine (1) according to one of the preceding claims,
suitable for monitoring an electric machine (1) in the form of an electric generator.

10. Method for monitoring a stator end winding (5, 6) of an electric machine (1) according to one of Claims 1 to 9, wherein the monitoring system is used during operation of the electric machine (1).

## Revendications

1. Machine (1) électrique ayant un système de contrôle pour contrôler la machine (1) électrique,
la machine électrique ayant une enveloppe (2) de génératrice et une bobine (3) de stator disposée dans l'enveloppe (2) de la génératrice et ayant une tête (5, 6) de bobine de stator,
dans laquelle une mini caméra (7, 8) est mise à l'intérieur de l'enveloppe (2) de la génératrice pour observer la tête (5, 6) de la bobine de stator,
dans laquelle la mini caméra (7, 8) est montée mobile sur des éléments (9, 10) de guidage,
dans laquelle les éléments (9, 10) de guidage sont constitués de manière à maintenir, pendant le fonctionnement de la machine (1) électrique, la mini caméra (7, 8) dans une position d'attente non critique.

2. Machine (1) électrique suivant la revendication 1, **caractérisée**
**en ce qu'**une observation de la tête (5, 6) de la bobine du stator a lieu pendant le fonctionnement de la machine (1) électrique.

3. Machine (1) électrique suivant la revendication 1 ou 2, dans laquelle l'enveloppe (2) de la génératrice est réalisée fermée d'une manière sensiblement étanche au gaz.

4. Machine (1) électrique suivant la revendication 1, 2 ou 3,
dans laquelle la machine (1) électrique est réalisée en ayant un refroidissement par de l'hydrogène.

5. Machine (1) électrique suivant l'une des revendications précédentes,
dans laquelle la mini caméra (7, 8) est réalisée en ayant une source lumineuse.

6. Machine (1) électrique suivant la revendication 1,
dans laquelle l'élément (9, 10) de guidage est réalisé sous la forme d'un rail.

7. Machine (1) électrique suivant la revendication 1 ou 6, dans laquelle l'élément (9, 10) de guidage est amagnétique.

8. Machine (1) électrique suivant l'une des revendications 1 à 7
dans laquelle l'élément (9, 10) de guidage est guidé suivant des orbites circulaires autour de la tête (5, 6) de la bobine de stator.

9. Machine (1) électrique suivant l'une des revendications précédentes,
propre au contrôle d'une machine (1) électrique réalisée en génératrice électrique.

10. Procédé de contrôle d'une tête (5, 6) de bobine de stator d'une machine (1) électrique suivant l'une des revendications 1 à 9,
dans lequel on utilise un système de contrôle pendant le fonctionnement de la machine (1) électrique.
